# EUROPEAN PATENT APPLICATION

(11) **EP 3 035 729 A1**
(43) Date of publication of application: **22.06.2016**
(21) Application number: 14198844.4
(22) Date of filing: 18.12.2014
(51) Int. Cl.: H04W 24/06, H04B 17/382, G01R 29/08, H04M 1/24

(54) **Apparatus for testing RF communication equipment**

(71) Applicant: Nokia Solutions and Networks Oy, 02610 Espoo (FI)
(72) Inventor: Tatsakis, Christos, 14121 Neo Iraklio (GR)
(74) Representative: Borgström, Markus

(57) **Abstract**

There is provided an apparatus for testing RF communication equipment. The apparatus comprises (a) a first compartment comprising a first antenna, (b) a second compartment comprising a second antenna, (c) a third compartment for receiving a mobile RF communication unit, wherein the third compartment is in communication with the first compartment through a first opening and in communication with the second compartment through a second opening, and (d) an adjustment mechanism for (i) adjusting the effective size of the first opening in order to control the strength of an RF signal between the first antenna and the mobile RF communication unit and (ii) adjusting the effective size of the second opening in order to control the strength of an RF signal between the second antenna and the mobile RF communication unit. Furthermore, a system, a method of manufacture, a method of testing and a corresponding computer program are provided.

## Description

### Field of Invention

The present invention relates to the field of testing of RF communication equipment, in particular to an apparatus, a system and a method for testing RF communication equipment and a method of manufacturing such apparatus.

### Art Background

A real-life handover happens when a single non-moving cell, connected to the core network, takes over an ongoing call or a data session of a moving mobile UE (end user) from an adjacent non-moving cell to which the call or data session is originally connected, without interruption of the ongoing call or data session.

In mobile test activities, a real-life handover case (like an inter-cell handover) is almost impossible to test in a lab environment with "open air" radio (i.e. signal communication through the aether without physical contact between the antennas of base station and mobile device). A very large test lab is needed with at least 2 antennas, each connected to different networks. Each antenna should have a very low radiance and the signal strength of each antenna should have a significant attenuation in comparison to its adjacent antenna. Only then the system can understand a loss in signal gain and perform handover activity.

Other external factors in the test lab can influence or even disturb handover tests. Usually other signals (2G, 3G, LTE, etc.) are present from various RF sources. There is a possibility that a handover to another, unwished, network will take place. Besides, it would be very difficult to adjust the gain of the antenna, and in general the test lab configuration, to the desired settings.

A practical problem is that a person should be physically present in the lab, walking from one antenna to the other while hoping that his call will not be handed over to a wrong network.

A radio frequency box (or RF box) isolates RF signals for test purposes. The RF box and "open air" radio are the only two means of accessing the mobile network in a lab environment. Therefore, the RF box is an essential tool in mobile test activities and is becoming more and more the standard for test purposes.

In many cases RF boxes are preferred over "open air" network access, because they operate in a small isolated area and are therefore controllable. Because of the high demands and the increasing complexity of the lab environment, RF boxes are preferred and steadily replace the "open air" access. The tendency seems to be that the majority of the "open air" connections will be eventually replaced and that most tests will be executed with RF boxes. However, until now a suitable way of testing handover using RF boxes has not been found and thus constitutes an obstacle to be solved.

A very important aspect of mobile test activities in a lab environment is to reproduce real-life situations and network functionality as the user would experience them.

Today, handover is not possible with RF boxes unless it is simulated. This has several major drawbacks: (1) Handover simulation involves adjusting the gain of the antennas and does therefore not represent a real-life handover situation. (2) Simulation-based testing is not efficient (as will be explained further below). (3) Large and expensive equipment is necessary to carry out the simulation.

Currently, at least the following methods for handover test are commonly used in automated and manual lab tests:
The current solution in automated tests is to use two antennas in an RF box that are connected to a programmable attenuator. The latter attenuates, in variable steps, the signal from the corresponding base station (NODE B) and passes the attenuated signal to the corresponding antenna. The UE signal is attached to a network of one antenna. The gain of this antenna is gradually lowered or completely shut down via software and/or the gain of the other antenna in the RF box is increased. In this way, and due to other RAN (Radio Access Network) settings (such as handover signal threshold parameters), handover from one cell to another cell takes place. The same mechanism may be applied when more antennas are used in an RF box.

The above solution is also applicable to manual tests. However, an easier solution that is more frequently used for manual tests is the following: Manual handover is usually done by a combination of a public safety antenna (low power) in an RF box and "open air" access outside the RF box. A mobile phone is placed in the RF box which signal attaches to the network of the antenna in the RF box. The mobile is manually removed from the RF box and the connection is taken over by the "open air" access of another network, as the mobile device suddenly loses contact with the antenna from inside the RF box.

In 3G and LTE networks, power control is an important parameter for handover activities. In downlink situations the base station (e.g., NODE B or eNB) adjusts its signal strength for a certain call or data session when the mobile user moves away or towards the antenna of the corresponding base station to keep the call or data session intact. This is also true for situations where the signal strength is degraded because of an obstacle between the mobile user and the antenna.

Programmable attenuators manipulate the power control of the radio network by interfering in the proper behavior of this mechanism. These devices are placed between the base station and the antenna and artificially (by means of attenuation) increase or decrease the antenna signal gain.

The behavior of the programmable attenuator is that it attenuates the radiated signals of the whole antenna and therefore affects the signal strengths towards all mobile users connected to the particular cell. This does not happen in a real network.

Accordingly, programmable attenuators do not reflect real-life behavior of the base station and, consequently, of the network. This behavior has impact on mobile test activity results. Moreover, all real-life situations cannot be simulated.

As mentioned above, in a downlink situation when the mobile user moves away from its connected cell, the signal strength will be weaker for that call or data session. This means that the base station will increase the gain of the signal, trying to maintain the connection. Eventually, the signal strength has decreased to such a low degree (depending on the RAN handover threshold parameters) that handover of the call or data session to another cell will take place. When there is no other cell available, the call or data session will be lost.

The opposite is true when a mobile user approaches the antenna. The signal sent from the base station will be weaker because less signal strength is needed for the connection.

Thus, programmable attenuators do not reflect real-life situations in 3G and LTE situations. More specifically, these devices decrease the signal towards the mobile user, implying that the mobile user moves away and force a handover to another cell. This is the opposite of a real-life situation.

Furthermore, programmable attenuators need at least two antennas and one mobile user for one handover. The gain of the original antenna to which the call or data session is connected will be lowered or completely shut down, while at the same time the gain of the other antenna (which is connected to another base station) will be increased. This operation is necessary in order to create a handover.

Thus, it can be seen that programmable attenuators do not make optimum use of the resources. Only one antenna is useful and can only be used at that moment for the specific handover test.

Additionally, programmable attenuators as currently offered on the market are expensive and bulky.

Therefore, there may be a need for a simple and efficient way of testing mobile communication equipment, in particular with regard to handover situations, which does not suffer from the drawbacks described above.

### Summary of the Invention

This need may be met by the subject matter according to the independent claims. Advantageous embodiments of the present invention are set forth in the dependent claims.

According to a first aspect of the invention, there is provided an apparatus for testing RF communication equipment. The apparatus comprises (a) a first compartment comprising a first antenna, (b) a second compartment comprising a second antenna, (c) a third compartment for receiving a mobile RF communication unit, wherein the third compartment is in communication with the first compartment through a first opening and in communication with the second compartment through a second opening, and (d) an adjustment mechanism for (i) adjusting the effective size of the first opening in order to control the strength of an RF signal between the first antenna and the mobile RF communication unit and (ii) adjusting the effective size of the second opening in order to control the strength of an RF signal between the second antenna and the mobile RF communication unit.

This aspect of the invention is based on the idea that a mobile RF communication unit (that is to be tested) can be arranged in the third compartment which is in communication with both the first and the second compartment through respective first and second openings, wherein the effective size of the first opening and the effective size of the second opening are adjustable. Thereby, the signal strength between the first antenna and the mobile RF communication unit and the signal strength between the second antenna and the mobile RF communication unit are correspondingly controllable. In other words, the adjustment of the effective size of the first and second opening allows emulation of changes in signal strength caused by signal path obstacles and/or varying distance between antenna and mobile RF communication unit as experienced under actual operation.

Each of the first, second and third compartments may in particular be formed as separate and substantially closed chambers within the apparatus, such that each compartment is effectively isolated from unwanted RF signals (e.g. RF signals originating from cellular communication networks in the surroundings of the apparatus). Thus, the compartments may e.g. comprise walls made from an RF isolating material, such as metallic walls, of any suitable shape and configuration. In particular, the compartments may have a rectangular box-like structure or cylindrical tubular structure.

The first opening allows RF communication signals to propagate between the first compartment and the third compartment. The first opening may in particular be constituted by a hole formed in a wall or other delimiting structure that separates the first and third compartments from each other.

Similarly, the second opening allows RF communication signals to propagate between the second compartment and the third compartment. The second opening may in particular be constituted by a hole formed in a wall or other delimiting structure that separates the second and third compartments from each other.

The first and second opening may in particular have a circular, elliptical, triangular, rectangular, or any other polygonal shape.

In the present context, the term "effective size" may in particular denote the cross-sectional area of an opening (i.e. the first or second opening) that is actually open or free in the sense that it is not blocked or covered by the adjustment mechanism or any other parts or elements. In other words, the effective size of each opening may be any area between zero and the total cross-sectional area of the opening itself.

The adjustment mechanism is configured to block or cover a desired part of each of the (first and second) openings in a variable manner, such that the effective size of each opening can be adjusted to a desired value. In particular, the adjustment mechanism may be configured to adjust the effective size of each opening independently. Alternatively or additionally, the adjustment mechanism may be configured to adjust the effective sizes of the openings in such a manner that a predetermined relation between the effective sizes is maintained.

By allowing adjustment of the effective sizes of the openings, the corresponding signal strengths can be controlled in a simple and realistic manner without the need for additional control of the signals supplied to the first and second antennas, e.g. by means of attenuators.

According to an embodiment of the invention, the adjustment mechanism is adapted to adjust the effective size of the first and second opening such that the effective size of the first opening gradually decreases while the effective size of the second opening gradually increases.

In this embodiment, the adjustment mechanism may e.g. comprise a moveable door or wall that is movably or slidably arranged in front of the first and second opening such that it blocks a part of the first opening and a part of the second opening to an extent determined by the specific position of the movable door.

In this embodiment, the apparatus is particularly suited for handover testing where the signal strength between the first antenna and the mobile RF communication unit is gradually decreased (over a period of time) while the signal strength between the second antenna and the mobile RF communication unit is correspondingly gradually increased. At some point in time, the signal strength between the first antenna and the mobile RF communication will reach a predetermined threshold value and the communication will be handed over to the second antenna.

According to a further embodiment of the invention, the adjustment mechanism comprises a disc-shaped member rotatably arranged relative to the first and second opening, the disc-shaped member comprising a cut-out portion positioned to overlap the first and/or second opening to an extent depending on a rotational position of the disc-shaped member, whereby the effective size of the first and second opening is adjustable by adjustment of the rotational position of the disc-shaped member.

In this embodiment, the effective size of the first opening is determined by how much of the first opening that is covered by the disc-shaped member and how much of the first opening that is overlapped by the cut-out portion of the disc-shaped member. If the first opening is totally covered by the disc-shaped member, the effective size is zero and no signal can be transmitted through the first opening, i.e. between the first antenna and the mobile RF communication unit. If, on the other hand, the entire first opening is overlapped by the cut-out portion of the disc-shaped member, the effective size of the first opening equals the actual size of the first opening and a signal may propagate unobstructed between the first antenna and the mobile RF communication unit through the first opening, i.e. the corresponding signal strength will be maximal.

Similarly, the effective size of the second opening is determined by how much of the second opening that is covered by the disc-shaped member and how much of the second opening that is overlapped by the cut-out portion of the disc-shaped member. If the second opening is totally covered by the disc-shaped member, the effective size is zero and no signal can be transmitted through the second opening, i.e. between the second antenna and the mobile RF communication unit. If, on the other hand, the entire second opening coincides with the cut-out portion of the disc-shaped member, the effective size of the second opening equals the actual size of the second opening and a signal may propagate unobstructed between the second antenna and the mobile RF communication unit through the second opening, i.e. the corresponding signal strength will be maximal.

The extent to which the cut-out portion of the disc-shaped member overlaps the first and/or second opening is depending on the rotational position of the disc-shaped member. In other words, the effective size of the first and second opening is easily adjustable by rotation of the disc-shaped member.

According to a further embodiment of the invention, the cut-out portion of the disc-shaped member is ovally shaped and larger than each of the first and second openings.

The oval shape and the fact that the cut-out portion is larger than each of the first and second openings makes it possible for the cut-out portion to at least partially overlap both the first and second openings. Accordingly, a handover from the first antenna to the second antenna may easily be conducted by rotating the disc-shaped member from a first position in which the cut-out portion overlaps most or all of the first opening to a second position in which the cut-out portion overlaps significantly less of the first opening and a significant part of the second opening. During the rotation from the first position to the second position, the effective size of the first opening gradually decreases while at the same time the effective size of the second opening gradually increases.

According to a further embodiment of the invention, the apparatus further comprises a driving unit adapted to rotate the disc-shaped member from a first rotational position to a second rotational position in a predetermined manner.

The driving unit may in particular be a servo motor arranged to rotate the disc-shaped member. Alternatively, the driving unit may be manually operable, i.e. by hand. In both cases, the disc-shaped member may be rotated from a first rotational position (start position) to a second rotational position (end position) over a predetermined period of time, preferably with a constant rotational speed.

According to a further embodiment of the invention, the adjustment mechanism comprises (a) a first disc-shaped member rotatably arranged relative to the first opening, the first disc-shaped member comprising a cut-out portion positioned to overlap the first opening to an extent depending on a rotational position of the first disc-shaped member, and (b) a second disc-shaped member rotatably arranged relative to the second opening, the second disc-shaped member comprising a cut-out portion positioned to overlap the second opening to an extent depending on a rotational position of the second disc-shaped member, whereby the effective sizes of the first and second openings are individually adjustable by respective adjustment of the rotational position of the first and second disc-shaped members.

In this embodiment, the adjustment mechanism comprises an individual disc-shaped member for each of the first and second openings. That is, both the first disc-shaped member and the second disc-shaped member are individually rotatable, such that the effective size of the first opening can be adjusted completely independent of the effective size of the second opening and vice versa.

This embodiment may be used in a similar manner as described above with regard to testing of handover from one (e.g. the first) antenna to the other (e.g. the second) antenna. Furthermore, it is particularly useful for testing handover in situations where the signal from the first (or second) antenna is suddenly cut off. The latter corresponds to the real-life situation where a mobile user suddenly loses the signal from a base station, e.g. when entering a building.

According to a further embodiment of the invention, the shape and size of the cut-out portion of the first disc-shaped member corresponds to the shape and size of the first opening, and/or the shape and size of the cut-out portion of the second disc-shaped member corresponds to the shape and size of the second opening.

By having shape and size of the cut-out portion corresponding to shape and size of the relevant opening, it is easily possible to adjust the effective size of the opening between maximum (fully open) and zero (completely closed).

According to a further embodiment of the invention, the apparatus further comprises (a) a first driving unit adapted to rotate the first disc-shaped member from a first rotational position to a second rotational position in a predetermined manner, and (b) a second driving unit adapted to rotate the second disc-shaped member from a first rotational position to a second rotational position in a predetermined manner.

Each of the first and second driving units may in particular be a servo motor arranged to rotate the first and second disc-shaped member, respectively. Alternatively, the driving units may be manually operable, i.e. by hand. In both cases, each of the first and second disc-shaped members may be individually and independently rotated from a first rotational position (start position) to a second rotational position (end position) over a predetermined period of time, preferably with a constant rotational speed.

According to a further embodiment of the invention, the first antenna is connectable to a first mobile communication network and the second antenna is connectable to a second mobile communication network.

The connectivity may in particular be provided by first and second sockets which are arranged in the apparatus such that they can receive corresponding cable plugs in order to connect the antennas to the corresponding mobile communication networks.

According to a further embodiment of the invention, the first compartment is adapted to receive a first mobile RF communication unit at a position within the first compartment where the first mobile RF communication unit may only communicate with the first antenna, and the second compartment is adapted to receive a second RF communication unit at a position within the second compartment where the second mobile RF communication unit may only communicate with the second antenna.

In other words, the first compartment is sufficiently large to contain a first mobile RF communication unit, such as a USB dongle. Furthermore, the geometric design of the first compartment is such that the first mobile RF communication unit is effectively shielded from signals transmitted by the second antenna (in the second compartment) or by a mobile RF communication unit in the third compartment. Similarly, the second compartment is sufficiently large to contain a second mobile RF communication unit and has a geometric design that provides an effective shielding of the second mobile RF communication unit from signals transmitted by the first antenna (in the first compartment) or by a mobile RF communication unit in the third compartment.

This embodiment makes it possible to carry out three tests simultaneously, i.e. one handover test for a mobile RF communication unit in the third compartment and two tests with the first and second mobile RF communication units in the first and second compartment.

The inner walls of all three compartments may preferably be coated with a signal absorbing material, such as absorbing foam.

According to a further embodiment of the invention, the apparatus further comprises a housing, wherein the first, second and third chamber are arranged within the housing.

The housing is preferably made of a metal, such as aluminum, or another RF isolating material that may effectively shield the compartments from surrounding communication signals.

According to a second aspect of the invention there is provided a system for testing RF communication equipment. The system comprises (a) a first apparatus according to the first aspect or any of the above embodiments, and (b) a second apparatus according to the first aspect or any of the above embodiments, wherein the third compartment of the first apparatus and the third compartment of the second apparatus form a common compartment for receiving the mobile RF communication unit, wherein the common compartment is in communication with the first and second compartment of the first apparatus and in communication with the first and second compartment of the second apparatus.

In other words, the system according to this aspect basically comprises two apparatuses according to the first aspect, which are arranged in such a way that the respective third compartments form a common compartment.

This system is useful for testing various situations where a mobile RF communication unit receives signals from up to four antennas at the same time.

It is noted that the system may be extended to contain even more apparatuses, such as a total of three or four, as desired.

According to a third aspect of the invention, there is provided a method of manufacturing an apparatus for testing RF communication equipment. The method comprises (a) providing a first compartment comprising a first antenna, (b) providing a second compartment comprising a second antenna, (c) providing a third compartment for receiving a mobile RF communication unit, wherein the third compartment is in communication with the first compartment through a first opening and in communication with the second compartment through a second opening, and (d) providing an adjustment mechanism for (i) adjusting the effective size of the first opening in order to control the strength of an RF signal between the first antenna and the mobile RF communication unit and (ii) adjusting the effective size of the second opening in order to control the strength of an RF signal between the second antenna and the mobile RF communication unit.

This aspect of the invention is essentially based on the same idea as the first and second aspects described above.

According to a fourth aspect of the invention, there is provided a method of testing handover from a first mobile communication network to a second mobile communication network by use of an apparatus according to the first aspect or any of the above embodiments. The method comprises (a) connecting the first antenna to the first mobile communication network, (b) connecting the second antenna to the second mobile communication network, (c) arranging a mobile RF communication unit within the third compartment, (d) operating the adjustment mechanism to allow communication between the mobile RF communication unit and the first antenna, (e) establishing communication between the mobile RF communication unit and the first antenna, (f) operating the adjustment mechanism to gradually reduce the effective size of the first opening while gradually increasing the effective size of the second opening, and (g) determining whether the communication is handed over to the second antenna when the effective size of the first opening is reduced with a predetermined amount corresponding to a predetermined reduction of the strength of the communication signal between the first antenna and the mobile RF communication unit.

According to a fifth aspect of the invention, there is provided a computer program comprising computer-executable instructions, which, when executed by a processing unit of a computer, causes the computer to perform the step of operating the adjustment mechanism and the step of determining whether the communication is handed over to the second antenna according to the fourth aspect.

It is noted that embodiments of the invention have been described with reference to different subject matters. In particular, some embodiments have been described with reference to method type claims whereas other embodiments have been described with reference to apparatus type claims. However, a person skilled in the art will gather from the above and the following description that, unless otherwise indicated, in addition to any combination of features belonging to one type of subject matter also any combination of features relating to different subject matters, in particular to combinations of features of the method type claims and features of the apparatus type claims, is part of the disclosure of this document.

The aspects defined above and further aspects of the present invention are apparent from the examples of embodiments to be described hereinafter and are explained with reference to the examples of embodiments. The invention will be described in more detail hereinafter with reference to examples of embodiments. However, it is explicitly noted that the invention is not limited to the described exemplary embodiments.

### Brief Description of the Drawing

Figure 1 shows a schematic view of an apparatus according to an embodiment of the invention in a first state.
Figure 2 shows a schematic view of the apparatus shown in

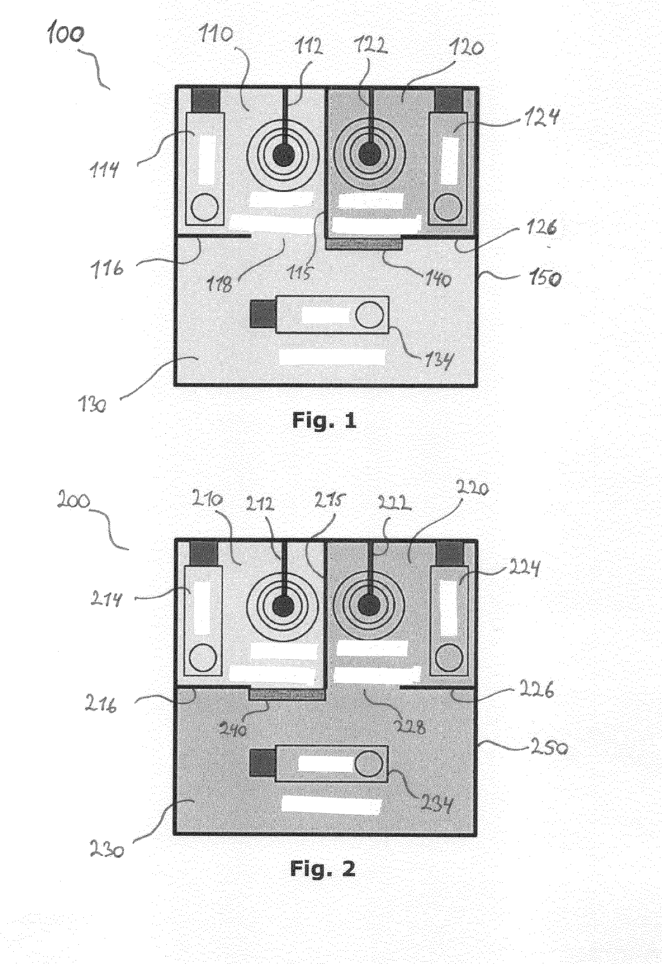

Figure 1 in a second state.

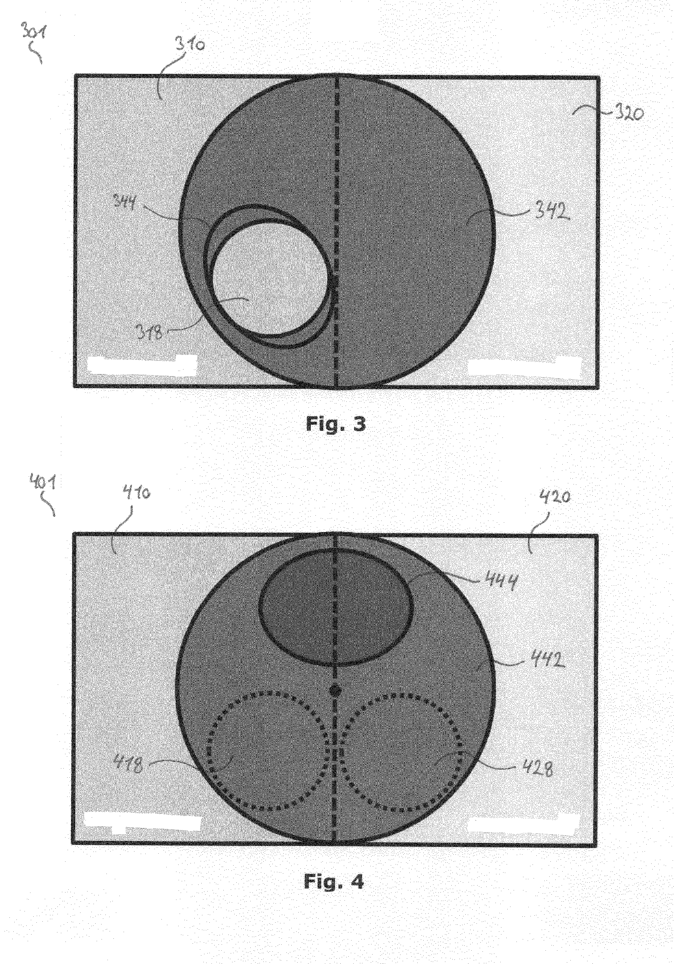

Figure 3 shows a schematic view of an adjustment mechanism according to an embodiment of the invention.
Figure 4 shows another schematic view of the adjustment mechanism shown in Figure 3.

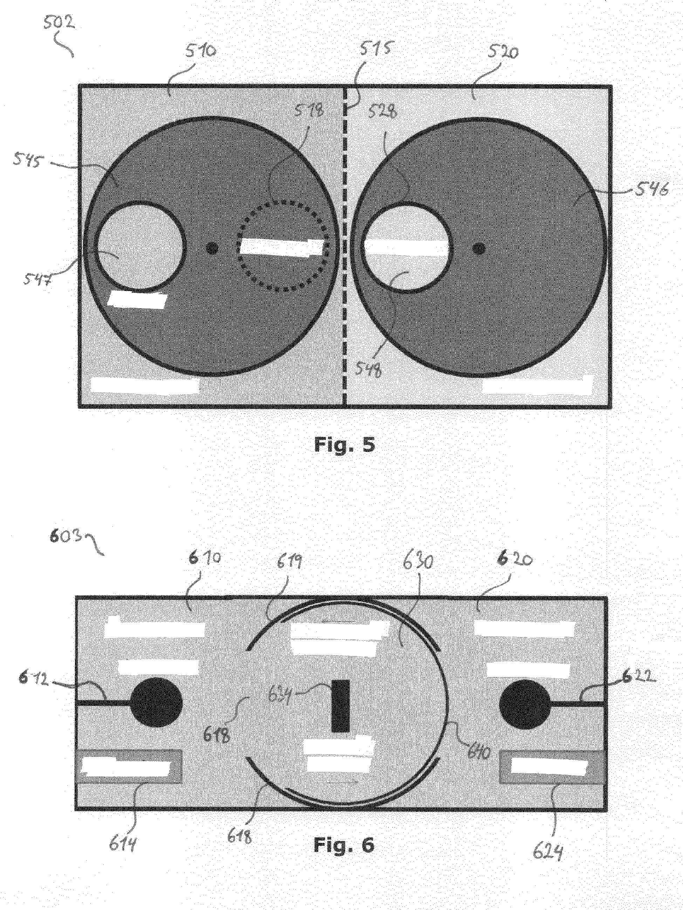

Figure 5 shows a schematic view of an adjustment mechanism according to an embodiment of the invention.
Figure 6 shows a schematic view of an apparatus according to an embodiment of the invention.

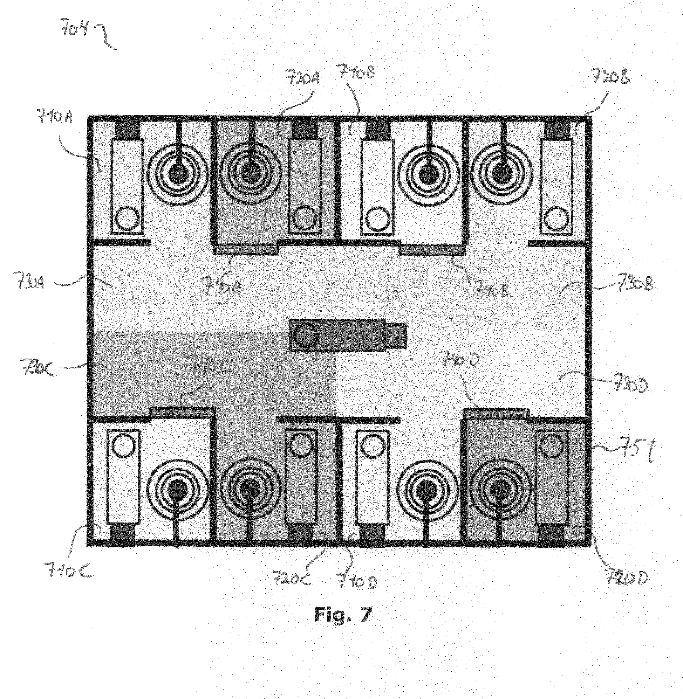

Figure 7 shows a schematic view of a system according to an embodiment of the invention.

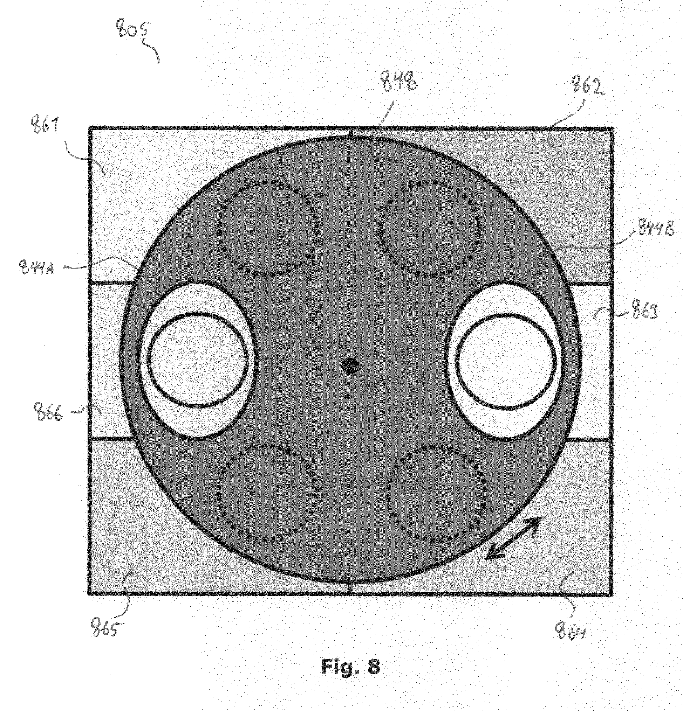

Figure 8 shows a schematic view of a system according to an embodiment of the invention.

### Detailed Description

The illustration in the drawing is schematic. It is noted that in different figures, similar or identical elements are provided with the same reference numerals or with reference numerals which differ only within the first digit.

Figure 1 shows a schematic view of an apparatus 100 for testing RF communication equipment according to an embodiment of the invention in a first state. More specifically, the apparatus 100 comprises a first compartment 110 with a first antenna 112, a second compartment 120 with a second antenna 122, and a third compartment 130 which is in communication with the first compartment 110 through a first opening 118. The third compartment 130 is further in communication with the second compartment 120 through a second opening which is, however, blocked by adjustment mechanism 140 in the state shown in Figure 1. The first compartment 110 is separated from the second compartment 120 by wall 115 and from the third compartment 130 by partial wall 116. The second compartment 120 is separated from the third compartment 130 by partial wall 126. The three compartments 110, 120 and 130 are arranged within a housing 150 which protects the compartments against unwanted RF communication signals from the outside.

A mobile RF communication unit 134 may be arranged in the third compartment 130 for testing. Similarly, mobile RF communication units 114 and 124 may be respectively arranged in the first compartment 110 and second compartment 120.

In operation, the adjustment mechanism 140 may be operated, either manually or by a computer controlled servo motor, in order to adjust the effective size of the first opening 118 and the second opening and thereby the signal strength between the first antenna 112 and the mobile RF communication unit 134 respectively between the second antenna 122 and the mobile RF communication unit 134 in accordance with the testing to be performed, e.g. handover testing.

Figure 2 shows a schematic view of the 200 apparatus shown in Figure 1 in a second state in which the adjustment mechanism is positioned to block the first opening 118 and instead leave the second opening 228 open for undisturbed signal passage between the second antenna 222 and the mobile RF communication unit 234.

It should be understood that the states shown in Figures 1 and 2 are the extreme states where one opening is left completely open (first opening 118 in Figure 1, second opening 228 in Figure 2) while the other opening (second opening in Figure 1, first opening in Figure 2) is completely blocked. Thus, the adjustment mechanism may be operated to provide a variety of combinations of more or less open or blocked openings 118, 228 as desired.

Figure 3 shows a schematic view of an adjustment mechanism 301 according to an embodiment of the invention. More specifically, the adjustment mechanism 301 comprises a circular disc 342 having an ovally shaped cut-out portion (or hole) 344. Referring to Figures 1 and 2, it is noted that the disc 342 is rotatably arranged in front of the partial walls 116, 216, 126, 226, the first opening 118, 318 and the second opening 228 such that when the disc 342 is rotated, the hole 344 will be displaced from the side of the first compartment 310 (the left-hand side in Figure 3) towards the side of the second compartment 320 (the right-hand side in Figure 3). The third compartment is above the plane of the drawing of Figure 3. The ovally shaped hole 344 is somewhat larger than the cross-sectional area of opening 318.

As shown in Figure 4, which shows another schematic view of the adjustment mechanism shown in Figure 3, the ovally shaped hole 444 may be rotated to a position where both the first opening 418 and the second opening 428 are completely closed. Further, it can be seen that the first and second openings 418, 428 are positioned relatively close to each other such that the ovally shaped hole 444 in the disc 442 may be positioned to cover a part of each opening 418, 428. Accordingly, if the position shown in Figure 3 is used as a starting position and the disc 442 is turned counterclockwise, the effective size of the first opening 418 will decrease gradually while, at the same time, the effective size of the second opening 428 will increase gradually. The signal strength between the mobile RF communication unit 134 and the first and second antennas 112, 122 will vary accordingly. Accordingly, handover of the communication between the first antenna 112 and the mobile RF communication unit 134 to the second antenna 122 may be easily tested by rotating the disc 442.

Figure 5 shows a schematic view of an adjustment mechanism 502 according to an embodiment of the invention. The adjustment mechanism 502 differs from the one shown in Figures 3 and 4 in that it comprises two separate circular discs 545 and 546. The first disc 545 is arranged in front of the first compartment 510 and comprises, like the disc 342, 442 discussed above, a cut-out portion (or hole) 547. Similarly, the second disc 546 is arranged in front of the second compartment 520 and comprises a hole 548. In the configuration shown in Figure 5, the first disc 545 is positioned such that the first opening 518 is completely covered (i.e. blocked) while the second disc 546 is positioned such that the second opening 528 coincides with the cut-out portion 548. Each disc 545, 546 may be rotated individually and independent from the other one, either manually by hand or by corresponding servo motors (not shown).

Figure 6 shows a schematic view of an apparatus 603 for testing RF communication equipment according to an embodiment of the invention. More specifically, the apparatus 603 comprises a first compartment 610 with a first antenna 612, a second compartment 620 with a second antenna 622, and a third compartment 630 for receiving a mobile RF communication unit 634. The third compartment 630 is arranged between the first and second compartments 610, 620 and separated from these by walls 618 and 619 formed as partial cylindrical structures. The first compartment 610 is in communication with the third compartment through first opening 618. Inside the partial cylinder constituted by walls 618 and 619, an adjustment mechanism 640 formed as another, slightly smaller partial cylinder is arranged. If the cylindrical adjustment mechanism is rotated clockwise or counterclockwise, a part of the first opening 618 will eventually be blocked while a corresponding part of the second opening on the opposite side will be correspondingly opened. Accordingly, the apparatus 603 may be operated to provide similar variations in signal strength as discussed above with regard to the embodiments of Figures 1 to 4.

Figure 7 shows a schematic view of a system 704 according to an embodiment of the invention. More specifically, the system 704 comprises four apparatuses (similar to the one shown in Figures 1 and 2), i.e. a first apparatus having first compartment 710A, second compartment 720A, third compartment 730A, and adjustment mechanism 740A; a second apparatus having first compartment 710B, second compartment 720B, third compartment 730B, and adjustment mechanism 740B; a third apparatus having first compartment 710C, second compartment 720C, third compartment 730C, and adjustment mechanism 740C; and a fourth apparatus having first compartment 710D, second compartment 720D, third compartment 730D, and adjustment mechanism 740D. The third compartments 730A, 730B, 730C, and 730D form a common compartment for receiving a mobile RF communication unit for testing. The system 704 is arranged in a shielding housing 751.

The system shown in Figure 7 allows testing of handover and other issues in LTE and 5G networks where a mobile RF communication unit may simultaneously communicate with several base stations. The specific operation of the adjustment mechanisms 740A, 740B, 740C, and 740D is similar to the above described embodiments and are thus not repeated here.

Figure 8 shows a schematic view of a system 805 according to an embodiment of the invention. More specifically, the system 805 comprises a total of six antenna compartments 861, 862, 863, 864, 865, and 866 arranged with one large disc 848 as an adjustment mechanism. The disc 848 comprises two ovally shaped cut-out portions 844A and 844B arranged in the vicinity of the disc perimeter and spaced 180° apart. When the disc 848 is rotated in either direction, simultaneous handover from one pair of antennas to another pair of antennas can be performed. It is noted that the mobile RF communication unit to be tested is to be placed on top of the drawing, such that the disc 848 is arranged between the mobile RF communication unit (not shown) and the compartments 861, 862, 863, 864, 865, and 866 below the disc 848.

Throughout the various embodiments shown in the drawings and discussed above, it is important that the different compartments are separated by shielding walls or structures such that no unwanted signals are received at any of the antennas. Furthermore, the inner surfaces of the compartments are preferably covered with absorbing foam to minimize reflections and the risk of standing waves. The adjustment mechanisms may be provided with gaskets of shielding or absorbing material. Furthermore, in order to reduce wear on the gaskets, a spring biased arrangement may be provided that lifts the disc(s) slightly away from the neighboring surface during rotation. The servo motor(s) may be provided at any suitable place within the apparatuses/systems and may be powered and/or controlled by an external computer via an appropriate interface board.

It is noted that the term "comprising" does not exclude other elements or steps and the use of the articles "a" or "an" does not exclude a plurality. Also elements described in association with different embodiments may be combined. It is further noted that reference signs in the claims are not to be construed as limiting the scope of the claims.

## Claims

1. An apparatus for testing RF communication equipment, the apparatus comprising
a first compartment comprising a first antenna,
a second compartment comprising a second antenna,
a third compartment for receiving a mobile RF communication unit, wherein the third compartment is in communication with the first compartment through a first opening and in communication with the second compartment through a second opening, and
an adjustment mechanism for (i) adjusting the effective size of the first opening in order to control the strength of an RF signal between the first antenna and the mobile RF communication unit and (ii) adjusting the effective size of the second opening in order to control the strength of an RF signal between the second antenna and the mobile RF communication unit.

2. The apparatus according to the preceding claim, wherein the adjustment mechanism is adapted to adjust the effective size of the first and second opening such that the effective size of the first opening gradually decreases while the effective size of the second opening gradually increases.

3. The apparatus according to claim 1 or 2, wherein the adjustment mechanism comprises a disc-shaped member rotatably arranged relative to the first and second opening, the disc-shaped member comprising a cut-out portion positioned to overlap the first and/or second opening to an extent depending on a rotational position of the disc-shaped member, whereby the effective size of the first and second opening is adjustable by adjustment of the rotational position of the disc-shaped member.

4. The apparatus according to the preceding claim, wherein the cut-out portion of the disc-shaped member is ovally shaped and larger than each of the first and second openings.

5. The apparatus according to claim 3 or 4, further comprising a driving unit adapted to rotate the disc-shaped member from a first rotational position to a second rotational position in a predetermined manner.

6. The apparatus according to claim 1 or 2, wherein the adjustment mechanism comprises
a first disc-shaped member rotatably arranged relative to the first opening, the first disc-shaped member comprising a cut-out portion positioned to overlap the first opening to an extent depending on a rotational position of the first disc-shaped member, and
a second disc-shaped member rotatably arranged relative to the second opening, the second disc-shaped member comprising a cut-out portion positioned to overlap the second opening to an extent depending on a rotational position of the second disc-shaped member,
whereby the effective sizes of the first and second openings are individually adjustable by respective adjustment of the rotational position of the first and second disc-shaped members.

7. The apparatus according to the preceding claim, wherein shape and size of the cut-out portion of the first disc-shaped member corresponds to the shape and size of the first opening, and/or wherein shape and size of the cut-out portion of the second disc-shaped member corresponds to the shape and size of the second opening.

8. The apparatus according to claim 6 or 7, further comprising
a first driving unit adapted to rotate the first disc-shaped member from a first rotational position to a second rotational position in a predetermined manner, and
a second driving unit adapted to rotate the second disc-shaped member from a first rotational position to a second rotational position in a predetermined manner.

9. The apparatus according to any of the preceding claims, wherein the first antenna is connectable to a first mobile communication network and the second antenna is connectable to a second mobile communication network.

10. The apparatus according to any of the preceding claims, wherein the first compartment is adapted to receive a first mobile RF communication unit at a position within the first compartment where the first mobile RF communication unit may only communicate with the first antenna, and wherein the second compartment is adapted to receive a second RF communication unit at a position within the second compartment where the second mobile RF communication unit may only communicate with the second antenna.

11. The apparatus according to any of the preceding claims, further comprising a housing, wherein the first, second and third chamber are arranged within the housing.

12. A system for testing RF communication equipment, the system comprising
a first apparatus according to any of the preceding claims, and
a second apparatus according to any of the preceding claims,
wherein the third compartment of the first apparatus and the third compartment of the second apparatus form a common compartment for receiving the mobile RF communication unit, wherein the common compartment is in communication with the first and second compartment of the first apparatus and in communication with the first and second compartment of the second apparatus.

13. A method of manufacturing an apparatus for testing RF communication equipment, the method comprising
providing a first compartment comprising a first antenna,
providing a second compartment comprising a second antenna,
providing a third compartment for receiving a mobile RF communication unit, wherein the third compartment is in communication with the first compartment through a first opening and in communication with the second compartment through a second opening, and
providing an adjustment mechanism for (i) adjusting the effective size of the first opening in order to control the strength of an RF signal between the first antenna and the mobile RF communication unit and (ii) adjusting the effective size of the second opening in order to control the strength of an RF signal between the second antenna and the mobile RF communication unit.

14. A method of testing handover from a first mobile communication network to a second mobile communication network by use of an apparatus according to any of claims 1 to 11, the method comprising
connecting the first antenna to the first mobile communication network,
connecting the second antenna to the second mobile communication network,
arranging a mobile RF communication unit within the third compartment,
operating the adjustment mechanism to allow communication between the mobile RF communication unit and the first antenna,
establishing communication between the mobile RF communication unit and the first antenna,
operating the adjustment mechanism to gradually reduce the effective size of the first opening while gradually increasing the effective size of the second opening, and
determining whether the communication is handed over to the second antenna when the effective size of the first opening is reduced with a predetermined amount corresponding to a predetermined reduction of the strength of the communication signal between the first antenna and the mobile RF communication unit.

15. A computer program comprising computer-executable instructions, which, when executed by a processing unit of a computer, causes the computer to perform the step of operating the adjustment mechanism and the step of determining whether the communication is handed over to the second antenna according to the preceding claim.
